Europäisches Patentamt

European Patent Office

Office européen des brevets

(19)

(11) EP 0 554 755 B1

(12) **EUROPÄISCHE PATENTSCHRIFT**

(45) Veröffentlichungstag und Bekanntmachung des Hinweises auf die Patenterteilung:
08.05.1996 Patentblatt 1996/19

(51) Int Cl.$^6$: **H01H 9/16**, H03F 1/30

(21) Anmeldenummer: 93101106.8

(22) Anmeldetag: 26.01.1993

(54) **Schaltungsanordnung zum Erzeugen einer Steuergrösse während des Schaltens von einer Schaltstellung zur nächsten**

Circuit for generating a control signal during the commutation of a switch from one position to the next

Circuit pour élaborer une grandeur de contrôle pendant la commutation d'un interrupteur d'une position à la suivante

(84) Benannte Vertragsstaaten:
**AT CH DE FR GB LI**

(30) Priorität: **04.02.1992 DE 4203059**

(43) Veröffentlichungstag der Anmeldung:
**11.08.1993 Patentblatt 1993/32**

(73) Patentinhaber: GRUNDIG E.M.V.
**Elektro-Mechanische Versuchsanstalt Max Grundig GmbH & Co. KG
D-90762 Fürth (DE)**

(72) Erfinder: **Elsässer, Dieter, Dipl.-Ing. (FH),
GRUNDIG E.M.V.
W-8510 Fürth/Bay (DE)**

(56) Entgegenhaltungen:
EP-A- 0 301 442     DE-A- 1 964 108
DE-A- 2 804 590     US-A- 3 679 819

- **PATENT ABSTRACTS OF JAPAN vol. 7, no. 194 (E-195)(1339) 24. August 1983 & JP-A-58 096 429 (MATSUSHITA) 8. Juni 1983**
- **PATENT ABSTRACTS OF JAPAN vol. 6, no. 6 (E-89)(884) 14. Januar 1982 & JP-A-56 126 329 (SANYO DENKI) 3. Oktober 1981**

**Beschreibung**

Die Erfindung betrifft eine Schaltungsanordnung zum Erzeugen einer Steuergröße während des Schaltens von einer Schaltstellung zur nächsten, gemäß dem Oberbegriff des Anspruchs 1.

Hochwertige elektronische Geräte der Unterhaltungselektronik, wie beispielsweise Vorverstärker für Audio-HiFi-Anlagen, müssen ein knackfreies Umschalten, zum Beispiel Umschalten der Audioquellen, gewährleisten. Es sind bereits elektronische Schaltungen bekannt, mit denen die Schaltspannung und die Umschaltspannungsspitzen unterdrückt werden können. Eine gattungsgemäße Schaltung ist in "radio mentor elektronik", Heft 11, 1976 beschrieben. Die dort beschriebene Schaltung besteht aus einzelnen Verstärkerbausteinen, von denen jeweils nur einer eingeschaltet ist. Die Schaltung der Verstärkerstufen erfolgt von einer Ansteuerlogik. Durch starke Gegenkopplung ist die Verstärkung der Stufen jeweils 1, und Umschaltknacke werden unterdrückt.

Beim Einsatz solcher elektronischer Schaltungen muß jedoch eine Einschränkung hinsichtlich der maximal zu schaltenden Signalamplituden in Kauf genommen werden.

Dieser Nachteil kann vermieden werden, wenn zum Umschalten von Audio-Quellen mechanische Schalter, wie beispielsweise aus DE-OS 22 06 744 bekannt, eingesetzt werden. Damit lassen sich sehr hohe Spannungen schalten. Aus bestimmten, hier nicht näher erläuterten Gründen, müssen diese mechanischen Schalter "verbindend" schalten, die Schaltstellung vor der Zielschaltstellung muß also noch erhalten sein, während die Zielverbindung bereits hergestellt ist.

Aus DE - A- 2 804 590 ist eine Schalteranordnung zur Stummschaltung in einem Rundfunkempfänger bekannt, bei der mit dem Umschalter ein Stummschalter gekoppelt ist, der während der Umschaltung den Signalweg erdet.

Die hier am Beispiel einer Umschaltung von Audio-Quellen eines Audio-HiFi-Gerätes beschriebene Schaltungsanordnung ist selbstverständlich auch für den Einsatz in den verschiedenartigsten Geräten verwendbar. Das können in der Unterhaltungselektronik Video- und Fernsehgeräte sein, sowie medizinische Geräte, Werkzeugmaschinen, Fahrzeuge usw.

Der Erfindung liegt nun die Aufgabe zugrunde, während des Schaltens eines mechanischen Schalters elektrisch eindeutig den Zustand festzustellen, während dem benachbarte Stellungen des Schalters verbunden sind, um daraus eine Steuergröße zu gewinnen, die beispielsweise zur Aktivierung einer Stummschaltung eines Verstärkers während des Umschaltens dient. Der festzustellende Zustand soll dabei völlig zeitunabhängig sein. Die Schalterbetätigung kann also sehr schnell oder extrem langsam erfolgen.

Diese Aufgabe wird durch die im Anspruch 1 gekennzeichneten Merkmale gelöst. Die Unteransprüche zeigen weitere vorteilhafte Ausgestaltungen der Erfindung auf.

Die erfindungsgemäße Schaltungsanordnung weist den Vorteil auf, daß auf überraschend einfache Art und Weise und solange eine kontaktverbindende Schalterstellung besteht, ein eindeutiges Kriterium zur Stummschaltung eines Verstärkers ableitbar ist.

Nach Anspruch 2 werden vorteilhafterweise für den Spannungsteiler Widerstände mit gleichem Widerstandswert eingesetzt.

Das im Anspruch 3 angegebene Schaltverhältnis der ersten Eingangsspannung zur zweiten Eingangsspannung am Schwellwertschalter von 3 : 2 gewährleistet eine sichere Schaltung des Schwellwertschalters, so daß dieser an seinem Ausgang einen eindeutigen High-Low-Pegel zur Ansteuerung von beispielsweise einer Stummschaltung liefert.

Die Erfindung wird nachstehend anhand des in den Zeichnungen dargestellten Ausführungsbeispiels näher erläutert.

Im einzelnen zeigen:

Fig. 1 eine erfindungsgemäße Schaltungsanordnung am Beispiel eines Schiebeschalters in einer eindeutigen Schaltstellung,

Fig. 2 dieselbe Schaltungsanordnung in einer verbindenden Umschaltstellung.

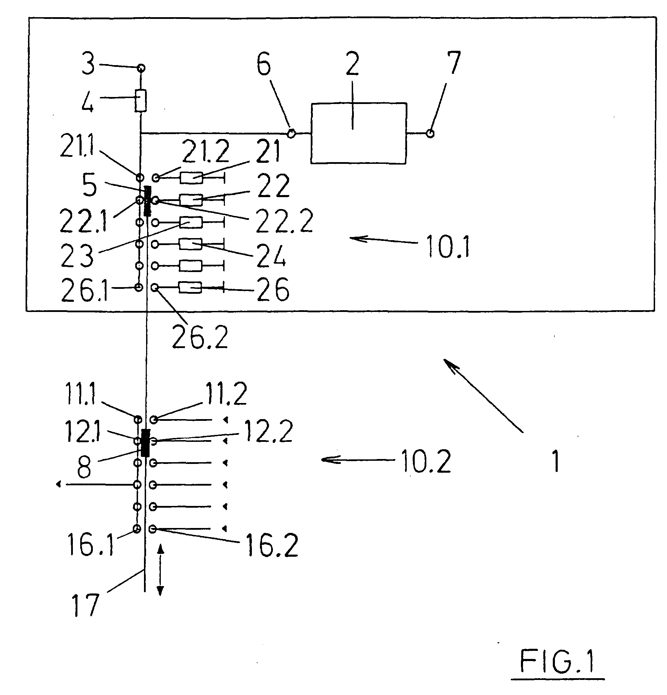

Die Schaltungsanordnung 1 in Fig. 1 beinhaltet einen Teil eines mechanisch betätigbaren Schiebeschalters 10, einen Schwellwertschalter 2 mit Spannungseingang 6 und Spannungsausgang 7, eine Spannungsquelle 3, Widerstände 4 und 21 bis 26, ein Schaltmesser 5 sowie Schaltkontakte 21.1 bis 26.2. Die beiden Teilstücke 10.1 und 10.2 sind Bestandteil eines Schiebeschalters 10. Während der Teil 10.2 in diesem Ausführungsbeispiel zugehörig zur Geräteelektronik eines Audio-Gerätes ist und zum Beispiel eine oder mehrere Audio-Quellen umschaltet, gehört der Teil 10.1 zur Schaltungsanordnung 1. Beide Schalterteile liegen in Reihe und sind von ein- und demselben Schieber 17 durchdrungen. Der Schieber 17 trägt die beiden Schaltmesser 5 und 8, wobei das Schaltmesser 5 die Kontakte 21.1 bis 26.2 des Schalterteilstückes 10.1 und das Schaltmesser 8 die Kontakte 11.1 bis 16.2 des Schalterteilstückes 10.2 bedient. Es können in einem anderen, hier nicht näher erläuterten Ausführungsbeispiel, selbstverständlich mehrere Schaltmesser pro Schalterteilstück vorhanden sein.

Der Schieber 17 wird beim Umschalten in Pfeilrichtung bewegt. Die Schaltmesser 5 und 8, die dabei synchron bewegt werden, nehmen nun nacheinander sogenannte Schaltstellungen und Bewegungsstellungen ein. In Fig. 1 ist eine Schaltstellung aufgezeichnet, in der das Kontaktmesser 5 die Kontakte 22.1 und 22.2 und das Kontaktmesser 8 die Kontakte 12.1 und 12.2 verbindet. In dieser Schaltstellung bewirkt eine an einer Spannungsquelle 3 anliegende Spannung $U_3$ im Span-

nungsteiler, bestehend aus Widerstand 4 und Widerstand 22, eine Spannung $U_{6.1}$ am Eingang 6 des Schwellwertschalters 2. Die an beiden Punkten 3 und 6 anliegenden Spannungen verhalten sich wie folgt:

$$\frac{U_3}{U_{6.1}} = \frac{R4+R22}{R22}.$$

Werden nun die Widerstandswerte von $R_4$ bis $R_{26}$ alle gleich groß gewählt, so ergibt sich ein Verhältnis von

$$\frac{U_3}{U_{6.1}} = \frac{2}{1}.$$

Wird nun der Schieber 17 auf die beiden Kontakte 21.1 und 21.2 zu bewegt, so wird eine Bewegungsstellung, eine sogenannte verbindende Stellung, erreicht. Diese dauert an, bis das Schaltmesser 5 die beiden Kontakte 22.1 und 22.2 verlassen hat.

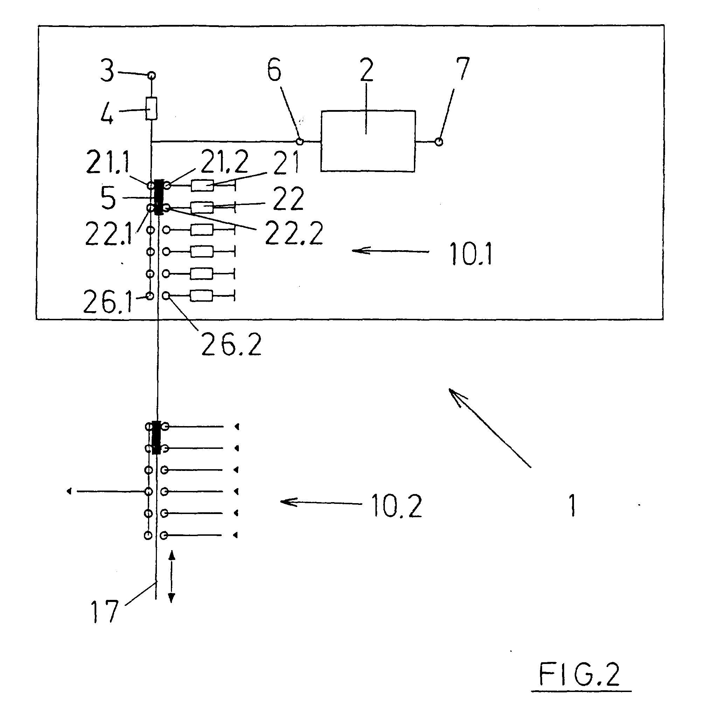

Wie in Fig. 2 dargestellt ist, sind während der Bewegungsstellung die Kontakte 21.1 bis 22.2 miteinander verbunden. Analog dazu verbindet das Schaltmesser 8 die Kontakte 11.1 bis 12.2. Der Spannungsteiler zur Erzeugung der Eingangsspannung $U_{6.2}$ am Punkt 6 des Schwellwertschalters 2 besteht nun aus dem Widerstand 4 und den beiden parallel geschalteten Widerständen 21 und 22.

Nunmehr verhalten sich die an den Punkten 3 und 6 anliegenden Spannungen folgendermaßen:

$$\frac{U_3}{U_{6.2}} = \frac{R4 + \left(\dfrac{R21 \cdot R22}{R21 + R22}\right)}{\left(\dfrac{R21 \cdot R22}{R21 + R22}\right)}.$$

Unter der obengenannten Voraussetzung, daß alle Widerstandswerte gleich groß gewählt werden, ergibt sich ein Verhältnis von

$$\frac{U_3}{U_{6.2}} = \frac{3}{1}.$$

Daraus wird durch Division der beiden Spannungen $U_{6.1}$ und $U_{6.2}$ ein Spannungsverhältnis von

$$\frac{U_{6.1}}{U_{6.2}} = \frac{3}{2}.$$

Mit diesem Spannungsverhältnis am Eingang 6 des Schwellwertschalters 2 wird eine sichere Schaltung desselben gewährleistet, an seinem Ausgang 7 steht damit ein eindeutiger High-Low-Pegel zur Verfügung, womit beispielsweise eine Stummschaltung gesteuert werden kann.

Die Aufgabe ist mit der erfindungsgemäßen Schaltungsanordnung gelöst. Die Schaltungsanordnung liefert ein eindeutiges Kriterium zur Stummschaltung eines Verstärkers, solange die kontaktverbindende Schaltstellung besteht.

**Patentansprüche**

1. Schaltungsanordnung (1) zum Erzeugen einer Steuergröße während des Schaltens von einer Schaltstellung zur nächsten, mit einem mechanisch arbeitenden Schalter (10), welcher Schaltmesser (5) und (8) aufweist, die synchron bewegt werden, wobei eine während des Kontaktübergreifens vorhandene Steuergröße für verschiedenartige Schaltvorgänge weiterverwendbar ist, **dadurch gekennzeichnet**, daß

- ein Schwellwertschalter (2) vorhanden ist, dessen Spannungseingang (6) nacheinander mit zwei Eingangsspannungen (U6.1, U6.2) beaufschlagt wird,

- ein Schieber (17) als Träger der Schaltmesser (5, 8) dient, wobei das erste Schaltmesser (5) die Kontakte (21.1 bis 26.2) eines ersten Schalterteilstücks (10.1) und das zweite Schaltmesser (8) die Kontakte (11.1 bis 16.2) eines zweiten Schalterteilstücks (10.2) bedient,

- ein erster Widerstand (4) zwischen einer Spannungsquelle (3) und den miteinander verbundenen, spannungsführenden Kontakten (21.1 bis 26.1) des ersten Schalterteilstücks (10.1) liegt,

- weitere Widerstände z.B. (21,22) vorgesehen sind, welche zwischen den nicht miteinander verbundenen, nichtspannungsführenden Kontakten z.B. (21.2, 22.2) des ersten Schalterteilstücks (10.1) und Masse liegen,

- die Schaltmesser (5, 8) derart breit gewählt werden, daß beim verschieben des Schiebers (17) zu einem Zeitpunkt zwei nebeneinanderliegende Kontakte jedes Schalterteilstücks zugleich kontaktiert werden und so die zugehörigen, mit der Masse verbundenen weiteren Widerstände der betreffenden Kontakte des ersten Schalterteilstücks (10.1) parallelgeschaltet werden,

- die erste Eingangsspannung (U6.1) von einem ersten Spannungsteiler, bestehend aus dem mit der Spannungsquelle (3) verbundenen ersten Widerstand (4) und einem einzigen der mit der Masse verbundenen weiteren Widerstände (22) erzeugt wird,

- die zweite Eingangsspannung (U6.2) von einem zweiten Spannungsteiler, bestehend aus dem mit der Spannungsquelle (3) verbundenen ersten Widerstand (4) und den beiden parallel zueinander geschalteten und mit der Masse verbundenen weiteren Widerständen (21,22) erzeugt wird.

2. Schaltungsanordnung (1) nach Anspruch 1 **dadurch gekennzeichnet**, daß die Widerstände (4, 21 bis 26) gleichen Widerstandswert besitzen.

3. Schaltungsanordnung (1) nach Anspruch 1 oder 2

**dadurch gekennzeichnet**, daß
das Verhältnis der ersten Eingangsspannung (U6.1) zur zweiten Eingangsspannung (U6.2) am Schwellweilschalter (2) 3 : 2 beträgt.

## Claims

1. Circuit arrangement (1) for generating a control variable during switching from one switch position to the next, having a mechanically operating switch (10) which has switch blades (5) and (8) which are moved synchronously, a control variable continuing to be usable during the contact overlap for various switching operations, characterized in that

   - a threshold-value switch (2) is present to whose voltage input (6) two input voltages ($U_{6.1}$, $U_{6.2}$) are applied consecutively,
   - a slider (17) serves as carrier for the switch blades (5, 8), the first switch blade (5) operating the contacts (21.1 to 26.2) of a first switch subsection (10.1) and the second switch blade (8) operating the contacts (11.1 to 16.2) of a second switch subsection (10.2),
   - a first resistor (4) is situated between a voltage source (3) and the interconnected voltage-carrying contacts (21.1 to 26.1) of the first switch subsection (10.1),
   - further resistors, for example (21, 22), are provided which are situated between the non-interconnected, non-voltage-carrying contacts, for example (21.2, 22.2) of the first switch subsection (10.1) and earth,
   - the switch blades (5, 8) are chosen as so wide that, during the displacement of the slider (17), two adjacently situated contacts of each switch subsection are simultaneously contacted at one point in time and the associated further resistors, connected to earth, of the respective contacts of the first switch subsection (10.1) are therefore connected in parallel,
   - the first input voltage ($U_{6.1}$) is generated by a first voltage divider comprising the first resistor (4) connected to the voltage source (3) and only one of the further resistors (22) connected to earth,
   - the second input voltage ($U_{6.2}$) is generated by a second voltage divider comprising the first resistor (4) connected to the voltage source (3) and the two further resistors (21, 22) connected in parallel with one another and to earth.

2. Circuit arrangement (1) according to Claim 1, characterized in that the resistors (4, 21 to 26) have the same resistance value.

3. Circuit arrangement (1) according to Claim 1 or 2, characterized in that the ratio of the first input voltage ($U_{6.1}$) to the second input voltage ($U_{6.2}$) is 3:2 at the threshold-value switch (2).

## Revendications

1. Montage (1) pour produire une grandeur de commande pendant la commutation depuis une position de commutation à la suivante, comportant un commutateur (10) à action mécanique, qui comporte des couteaux de commutation (5) et (8), qui sont déplacés de façon synchrone, une grandeur de commande présente pendant le transfert de contact pouvant continuer à être utilisée pour des processus de commutation de différents types, caractérisé en ce que

   - il est prévu un commutateur à valeur de seuil (2), dont l'entrée de tension (6) est chargée successivement par deux tensions d'entrée (U6.1, U6.2),
   - un poussoir (17) servant de support des couteaux de commutation (5, 8), le premier couteau de commutation (5) actionnant les contacts (21.1 à 26.2) d'une première pièce (10.1) du commutateur, et le second couteau de commutation (8) activant les contacts (11.1 à 16.2) d'une seconde pièce (10.2) du commutateur,
   - une première résistance (4) située entre une source de tension (3) et les contacts reliés entre eux et placés sous tension (20.1 à 26.1) de la première pièce (10.1) du commutateur,
   - il est prévu d'autres résistances (par exemple 21, 22), qui sont situées entre les contacts (par exemple 21.2, 22.2), qui ne sont pas reliés entre eux et ne sont pas placés sous tension, de la première pièce (10.1) du commutateur et la masse,
   - les couteaux de commutation (5,8) sont choisis avec une largeur telle que, lors du déplacement du poussoir (17), à un instant, deux contacts situés côte-à-côte de chaque pièce du commutateur sont placés simultanément en contact et de ce fait les autres résistances associées, qui sont reliées à la masse, sont branchées en parallèle avec les contacts considérés de la première pièce (10.1) du commutateur,
   - la première tension d'entrée (U6.1) est produite par un premier diviseur de tension, constitué par la première résistance (4), qui est reliée à la source de tension (3), et par une seule des autres résistances (22) reliées à la masse,
   - la seconde tension d'entrée (U6.2) est produite par un second diviseur de tension qui est constitué par la première résistance (4) reliée à la source de tension (3) et par les deux autres résistances (21,22) qui sont branchées en parallèle entre elles et sont reliées à la masse.

2. Montage (1) selon la revendication 1, caractérisé en ce que les résistances (4, 21 à 26) possèdent la même valeur résistive.

3. Montage (1) selon la revendication 1 ou 2, caractérisé en ce que le rapport de la première tension d'entrée (U6.1) à la seconde tension d'entrée (U6.2) dans le commutateur à valeur de seuil (2) est égal à 3:2.

FIG.1

FIG.2